# EUROPEAN PATENT SPECIFICATION

(11) **EP 2 998 754 B1**
(45) Date of publication and mention of the grant of the patent: **30.12.2020**
(21) Application number: 14813101.4
(22) Date of filing: 28.05.2014
(51) Int. Cl.: G01R 31/36, G01R 31/3828, G01R 31/3835

(54) **SECONDARY BATTERY STATUS DETECTION DEVICE AND SECONDARY BATTERY STATUS DETECTION METHOD**
VORRICHTUNG ZUR ERKENNUNG DES STATUS EINER SEKUNDÄRBATTERIE UND VERFAHREN ZUR ERKENNUNG DES STATUS EINER SEKUNDÄRBATTERIE
DISPOSITIF DE DÉTECTION DE STATUT DE BATTERIE SECONDAIRE, ET PROCÉDÉ DE DÉTECTION DE STATUT DE BATTERIE SECONDAIRE

(30) Priority: 18.06.2013 JP 2013127848
(43) Date of publication of application: 23.03.2016
(73) Proprietor: Furukawa Electric Co., Ltd., Chiyoda-ku Tokyo 100-8322 (JP); Furukawa Automotive Systems Inc., Inukami-gun, Shiga 522-0242 (JP)
(72) Inventor: ISHIHARA, Hideaki, Inukami-gun, Shiga 522-0242 (JP); SATO, Etsuzo, Inukami-gun, Shiga 522-0242 (JP)
(74) Representative: Horn Kleimann Waitzhofer Patentanwälte PartG mbB
(86) International application number: PCT/JP2014/064191
(87) International publication number: WO 2014/203698

(56) References cited:
- DE-A1- 3 712 629
- DE-A1-102005 055 165
- JP-A- 2000 270 402
- JP-A- 2007 078 525
- JP-A- 2007 078 525
- JP-A- 2008 260 506
- JP-A- 2013 038 831
- US-A1- 2012 072 145

## Description

### Technical Field

The present invention relates to a secondary battery state detecting device and a secondary battery state detecting method.

### Background Art

In Patent Document 1, a technology to detect a state of charge (SOC) of a lead-acid battery is disclosed. In this technology, a relational expression between a terminal voltage and a discharge current is found in advance as for a lead-acid battery whose SOC is already known, and a coefficient of the relational expression is found from a state when the SOC is different. The terminal voltage and the discharge current are applied to the found relational expression, and thereby, it is possible to find the SOC of the lead-acid battery at an arbitrary time.

Further, Patent Document 2 discloses a method for determining a battery capacity for a vehicle battery, wherein open circuit voltages of the battery are measured during ignition startups. A battery parameter is estimated for the battery that is a function of a present open circuit voltage measurement for a present ignition startup, a function of at least one open circuit voltage observation of a previous ignition startup, a function of a current draw integration over a time period from a previous ignition startup event to a present ignition startup event, and a function of an adjustment factor.

Patent Document 3 discloses a method of controlling a battery status which can uniformly manage the mode of a change in internal resistance against a change in open voltage for different types of batteries.

Moreover, Patent Document 4 discloses a vehicle power unit comprising an engine managing circuit for detecting an engine start battery state quantity, and for determining in-vehicle battery conditions based on the detected engine start battery state quantity. Based on detected or inputted information, the engine managing circuit determines whether or not an in-vehicle battery has been exchanged. If the in-vehicle battery is determined as having been exchanged, a predetermined engine start prompting operation is performed as a control operation for prompting engine start after the exchange. The control operation includes giving a warning for prompting a driver's engine start operation after detecting battery exchange, and performing automatic engine start if engine start is yet to be performed. After performing the engine start, the voltage and current of the in-vehicle battery are measured.

Patent Document 5 discloses a device for verifying the operation time of a secondary battery in a vehicle and for determining a state of charge of the secondary battery.

### Prior Art Document

### Patent Document

Patent Document 1: Japanese Patent Application Laid-open No. 2005-188965
Patent Document 2: US 2012/072145 A1
Patent Document 3: JP 2007 078525 A
Patent Document 4: DE 10 2005 055165 A1
Patent Document 5: DE 37 12 629 A1

### Summary of the Invention

### Problems to be Solved by the Invention

Incidentally, in an assembling process of a vehicle, it is judged whether or not a secondary battery is normal based on a state detection result by a secondary battery state detecting device. When it is not normal, it is judged to be defective, and there is a case when the secondary battery is exchanged into a new secondary battery.

When the state detection device is attached to the secondary battery, there is a case when the state of the secondary battery is detected at times when a state in which a contact between a terminal of the secondary battery and the state detecting device is not good occurs, and when a state in which electric power is supplied from the secondary battery to a load occurs. In such cases, a normal detection cannot be performed, and therefore, the secondary battery is judged to be abnormal by mistake, and there is a problem in which the exchange of the secondary battery is executed though the exchange is not necessary.

An object of the present invention is to provide a secondary battery state detecting device and a secondary battery state detecting method capable of accurately detecting a state of a secondary battery when the secondary battery is mounted on a vehicle.

### Means for Solving the Problems

To solve the above-stated problems, a secondary battery state detecting device according to claim 1 and a secondary battery state detecting method according to claim : 3 are provided. Advantageous aspects of the secondary battery state detecting device are detailed in the dependent claim According to an aspect, a secondary battery state detecting device detecting a state of a secondary battery mounted on a vehicle is provided, wherein a first operation mode is an initial operation mode in a case newly connected to the secondary battery, and a second operation mode is a normal operation mode after the first operation mode., The secondary battery state detecting device includes: an initial state detecting unit which makes the operation mode transit to the first operation mode, and detects an initial state of the secondary battery with reference to a terminal voltage of the secondary battery in a case connected to the secondary battery; and a normal state detecting unit which makes the operation mode transit to the second operation mode, and detects the state of the secondary battery at a normal time based on the terminal voltage and a charge/discharge current of the secondary battery at a predetermined timing after the state of the secondary battery is detected by the initial state detecting unit.

With such a constitution, it is possible to accurately detect the state of the secondary battery when the secondary battery is mounted on the vehicle.

Further, according to another aspect, the normal state detecting unit is transit to the second operation mode when an ignition switch of the vehicle is turned into on state.

With such a constitution, it is possible to detect the state during a period when the state of the secondary battery is stable.

Further, according to another aspect, when the initial state of the secondary battery is judged to be not normal, the initial state detecting unit presents information indicating the state via a higher device.

With such a constitution, it is possible to notify the workers that the secondary battery is not normal.

Further, according to another aspect, the initial state detecting unit detects the state of the secondary battery in plural times, and detects the state of the secondary battery based on an average value of the plural detections.

With such a constitution, it is possible to accurately detect the state of the secondary battery based on the average value of the plural times.

Further, according to another aspect, the initial state detecting unit detects the state of the secondary battery in plural times, and detects the state of the secondary battery based on a maximum value of the plural detections.

With such a constitution, it is possible to accurately detect the state of the secondary battery based on the maximum value of the plural times.

Further, a secondary battery state detecting method detecting a state of a secondary battery mounted on a vehicle is provided, wherein a first operation mode is an initial operation mode in a case newly connected to the secondary battery, and a second operation mode is a normal operation mode after the first operation mode. The secondary battery state detecting method includes: an initial state detecting step which makes the operation mode transit to the first operation mode, and detects an initial state of the secondary battery with reference to a terminal voltage of the secondary battery in a case connected to the secondary battery; and a normal state detecting step which makes the operation mode transit to the second operation mode, and detects the state of the secondary battery at a normal time based on the terminal voltage and a charge/discharge current of the secondary battery at a predetermined timing after the state of the secondary battery is detected in the initial state detecting step.

With such a method, it is possible to accurately detect the state of the secondary battery when the secondary battery is mounted on the vehicle.

### Effect of the Invention

According to the present invention, it becomes possible to provide a secondary battery state detecting device and a secondary battery state detecting method capable of accurately detecting a state of a secondary battery when the secondary battery is mounted on a vehicle.

### Brief Description of Drawings

Fig. 1 is a view illustrating a configuration example of a secondary battery state detecting device according to an embodiment of the present invention.
Fig. 2 is a block diagram illustrating a detailed configuration example of a control part in Fig. 1.
Fig. 3 is a view illustrating a change of a voltage and a current at a vehicle assembling time.
Fig. 4 is a view illustrating a transition example of an operation mode of the embodiment of the present invention.
Fig. 5 is a flowchart to explain operations of the embodiment.
Fig. 6 is a view illustrating a change of the voltage of the secondary battery after a vehicle travel.
Fig. 7 is a view illustrating a change of the voltage of the secondary battery at the vehicle assembling time.

### Best Mode for Carrying out the Invention

Next, an embodiment of the present invention will be described.

### (A) Description of Constitution of Embodiment

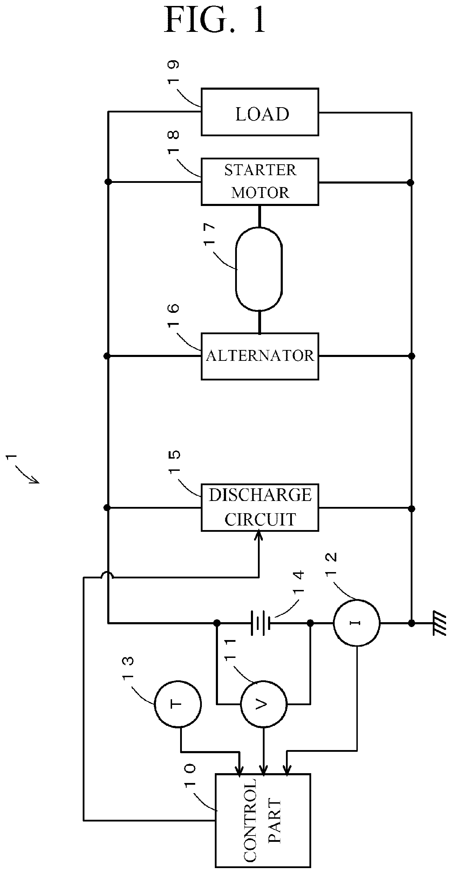

Fig. 1 is a view illustrating a power supply system of a vehicle having a secondary battery state detecting device according to an embodiment of the present invention. In this drawing, a secondary battery state detecting device 1 includes a control part 10, a voltage sensor 11, a current sensor 12, a temperature sensor 13, and a discharge circuit 15 as major components, and detects a state of a secondary battery 14. Here, the control part 10 refers to outputs from the voltage sensor 11, the current sensor 12, and the temperature sensor 13 to detect the state of the secondary battery 14. The voltage sensor 11 detects a terminal voltage of the secondary battery 14, and notifies the control part 10. The current sensor 12 detects a current flowing in the secondary battery 14, and notifies the control part 10. The temperature sensor 13 detects an environmental temperature of the secondary battery 14 in itself or a periphery thereof, and notifies the control part 10. The discharge circuit 15 is made up of, for example, a semiconductor switch, a resistance element, and so on which are connected in series, and it makes the secondary battery 14 intermittently discharge by an on/off control of the semiconductor switch by the control part 10.

The secondary battery 14 is made up of, for example, a lead-acid battery, a nickel-cadmium battery, a nickel hydride battery, a lithium ion battery, or the like, is charged by an alternator 16, drives a starter motor 18 to start an engine and supplies electric power to a load 19. The alternator 16 is driven by an engine 17, generates an alternating-current power, converts into a direct-current power by a rectifying circuit, and charges the secondary battery 14.

The engine 17 is made up of, for example, a reciprocal engine such as a gasoline engine and a diesel engine, or a rotary engine, and so on, started by the starter motor 18, drives a driving wheel via a transmission to provide a vehicle with a propulsive force, and generates electric power by driving the alternator 16. The starter motor 18 is made up of, for example, a direct current motor, generates a rotational force by the electric power supplied from the secondary battery 14, and starts the engine 17. The load 19 is made up of, for example, an electric steering motor, a defogger, an ignition coil, a car audio, a car navigation, and so on, and operated by the electric power from the secondary battery 14. Note that an electric motor may be used instead of the engine 17.

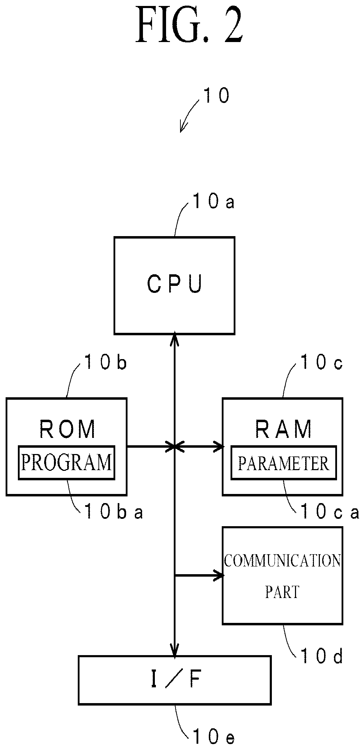

Fig. 2 is a view illustrating a detailed configuration example of the control part 10 illustrated in Fig. 1. As illustrated in this drawing, the control part 10 includes a CPU (Central Processing Unit) 10a, a ROM (Read Only Memory) 10b, a RAM (Random Access Memory) 10c, a communication part 10d, and an I/F (Interface) 10e. Here, the CPU 10a controls each part based on programs 10ba stored at the ROM 10b. The ROM 10b is made up of a semiconductor memory, and so on, and stores the programs 10ba, and so on. The RAM 10c is made up of the semiconductor memory, and so on, and stores data generated when the programs 10ba are executed, and parameters 10ca of later-described tables, numerical formulas, or the like. The communication part 10d performs communications with ECU (Electronic Control Unit) being a higher device and so on, and notifies detected information to the higher device. The I/F 10e converts signals supplied from the voltage sensor 11, the current sensor 12, and the temperature sensor 13 into digital signals, downloads them, and supplies a drive current to the discharge circuit 15 to control it.

### (B) Description of Principles of Operations of Embodiment

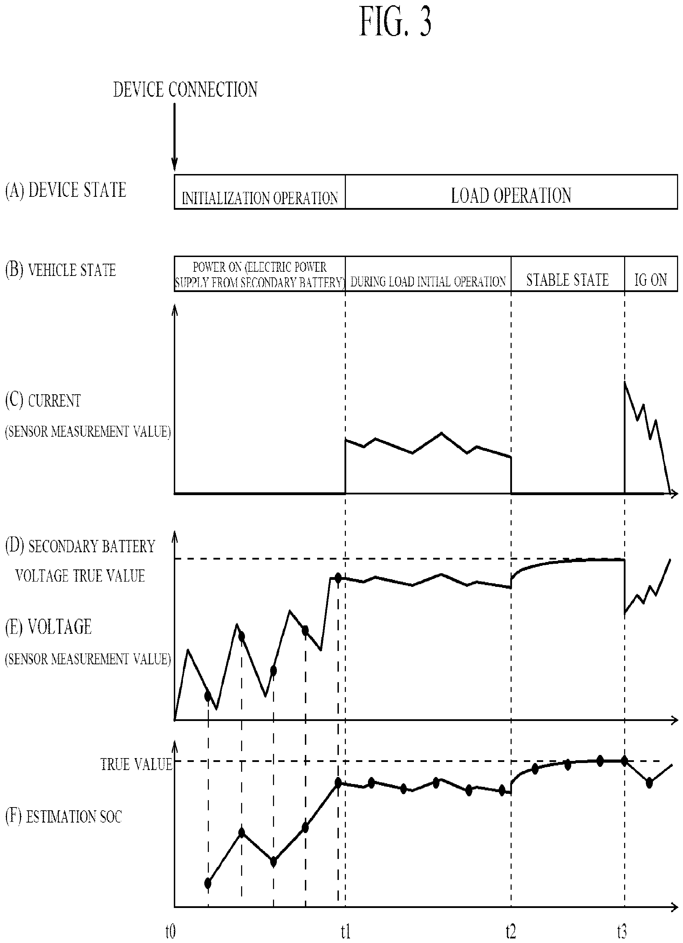

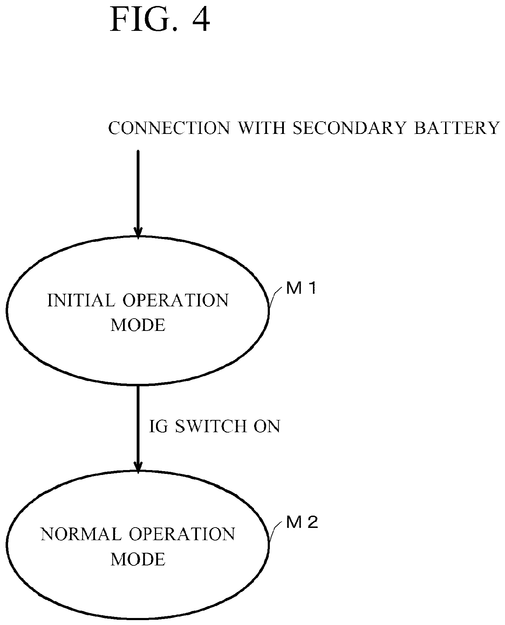

Next, principles of operations of the embodiment are described with reference to the drawings. Fig. 3 is a timing chart to explain operations when the secondary battery state detecting device 1 is attached to the secondary battery 14 at an assembling process of a vehicle in Fig. 3. Note that in the assembling process of the vehicle, at first, the load 19 is attached, and the secondary battery state detecting device 1 is attached. After the secondary battery 14 is mounted, the secondary battery state detecting device 1 and the load 19 are connected to the secondary battery 14. As illustrated in Fig. 3, it is assumed that the connection of the secondary battery state detecting device 1 to the secondary battery 14 is started at a timing t0, then as illustrated in Fig. 3(B), electric power is supplied from the secondary battery 14 to the secondary battery state detecting device 1, and the secondary battery state detecting device 1 becomes in an initialization operation, then is transit to an initial operation mode M1 relating to a state detection of the secondary battery 14. Note that the initialization operation is, for example, an operation to read out the program 10ba stored at the ROM 10b, loads at the RAM 10c to make it an operation enable state. Besides, the initial operation mode M1 is an operation mode to be transit to when the secondary battery state detecting device 1 is newly connected to the secondary battery 14 as illustrated in Fig. 4, and as it is described later, it is an operation mode in which the SOCs are estimated from the terminal voltage of the secondary battery 14 to store at the RAM 10, and for example, a maximum value thereof is presented as an initial SOC.

During the initialization operation, the voltage is measured by the voltage sensor 11, but while the secondary battery state detecting device 1 is attached, for example, a connection part of the secondary battery state detecting device 1 is attached so that it is screwed into the terminal of the secondary battery 14, an electrical connection state thereby changes, and therefore, measured voltages are not stable as illustrated in Fig. 3(E) resulting from the change of a contact resistance. At this time, the CPU 10a finds the SOC from the voltage detected by the voltage sensor 11. Namely, there is a correlation between the voltage of the secondary battery 14 and the SOC, and therefore, the SOC is found from the voltage detected by the voltage sensor 11 based on the correlation, and is stored at the RAM 10c. In Fig. 3(F), each black circle represents a timing when the SOC is estimated. As stated above, the voltages detected by the voltage sensor 11 fluctuate violently, and therefore, the SOCs detected based on the voltages detected by the voltage sensor 11 fluctuate violently and do not become constant as illustrated in Fig. 3(F).

When the initial operation finishes, at a timing t1, the electric power supply from the secondary battery 14 to the load 19 is started, and it becomes a state in an initial operation of the load. In this state, the secondary battery state detecting device 1 becomes a surely electrically connected state relative to the secondary battery 14, and therefore, the detection value of the voltage sensor 11 does not fluctuate resulting from the change of the contact resistance. However, during the load initial operation, there is a case when the current flows in the load 19, and therefore, the voltage detected by the voltage sensor 11 slightly fluctuates as illustrated in Fig. 3(E) resulting from a voltage drop caused by internal impedance of the secondary battery 14. Therefore, as illustrated in Fig. 3(F), the value of the SOC estimated from the voltage detected by the voltage sensor 11 slightly fluctuates. The CPU 10a specifies the maximum value of the SOCs which are estimated until that time, and sets the maximum value as the initial SOC.

At a timing t2, when the operation of the load 19 finishes, it becomes a stable operation state. In this state, the power supply from the secondary battery 14 to the load decreases, and therefore, the voltage of the secondary battery 14 is gradually restored to a normal state. At this time, the estimated SOC values increase in accordance with the increase of the voltage as illustrated in Fig. 3(F), and becomes a state close to a true value. The CPU 10a specifies the maximum value of the SOCs which are estimated until that time, and set the maximum value as the initial SOC.

At a timing t3, an IG (Ignition) switch of the vehicle is operated, and the starter motor 18 is rotated, then the CPU 10a detects the operation of the IG switch, and finds the initial SOC as the SOC in the initial operation mode M1. Namely, the CPU 10a sets the maximum value of the SOCs which are estimated at the timings t1 to t3 as the initial SOC. Next, the CPU 10a compares the initial SOC and a predetermined threshold value (for example, 80%). When the initial SOC is less than the predetermined threshold value (initial SOC < 80%), the CPU 10a judges that the secondary battery 14 is not normal, and for example, notifies a higher device (not-illustrated) of the state via the communication part 10d. The higher device receives the notification from the communication part 10d, and presents a message indicating that the secondary battery 14 is not normal to a presentation part. As a result, workers engaged in the assembling work are able to know that the secondary battery 14 is not normal by referring to the presented message. Note that it may be set such that the secondary battery state detecting device 1 does not judge but reports the initial SOC to the higher device, and the higher device judges to present the judged result to the presentation part.

The initial SOC at the initial operation mode M1 is found, then the CPU 10a is transit from the initial operation mode M1 to a normal operation mode M2 as illustrated in Fig. 4. In the normal operation mode M2, the CPU 10a is able to find the SOC of the secondary battery 14 by, for example, setting the initial SOC found at the initial operation mode M1 as an initial value, and adding a charge/discharge current integrated value which is calculated based on the output of the current sensor 12 to the initial SOC. Note that properties of the secondary battery 14 change depending on a temperature, and therefore, a correction process by the temperature may be executed with reference to the output of the temperature sensor 13.

Note that when the secondary battery state detecting device 1 is detached from the secondary battery 14 during an operation in the normal operation mode M2 (for example, when it is detached to exchange the battery), the normal operation mode M2 is finished, and when it is attached to the secondary battery 14 again, it starts from the initial operation mode M1.

As described above, according to the embodiment of the present invention, the beginning when the secondary battery state detecting device 1 is connected to the secondary battery 14 is set to be the initial operation mode M1, and after the initial operation mode M1 is finished (after the IG switch is operated in the above example), it is set to be the normal operation mode M2, the estimation methods of the SOC are changed in each of the operation modes, and thereby, it is possible to accurately find the SOC in each of the operation modes. As a result, in the initial operation mode M1, the SOCs are estimated in plural times based on the voltage of the secondary battery 14, the maximum value is found from among the estimated plurality of SOCs, then the maximum value is presented to the assembling workers as the SOC in the initial operation mode, and thereby, it becomes possible to accurately judge whether or not the secondary battery 14 is normal. Besides, the maximum value is found and presented, and thereby, it is possible to exclude the SOCs estimated under unstable states such as, for example, at the timings t0 to t1 and the SOCs estimated when the current is supplied to the load 19 and the voltage drops such as at the timings t1 to t2. It is thereby possible to judge based on the SOC which is closer to the true value, and therefore, it is possible to prevent that the normal secondary battery 14 is judged to be abnormal to let the secondary battery 14 in itself go to waste, or an unnecessary labor caused by the exchange occur.

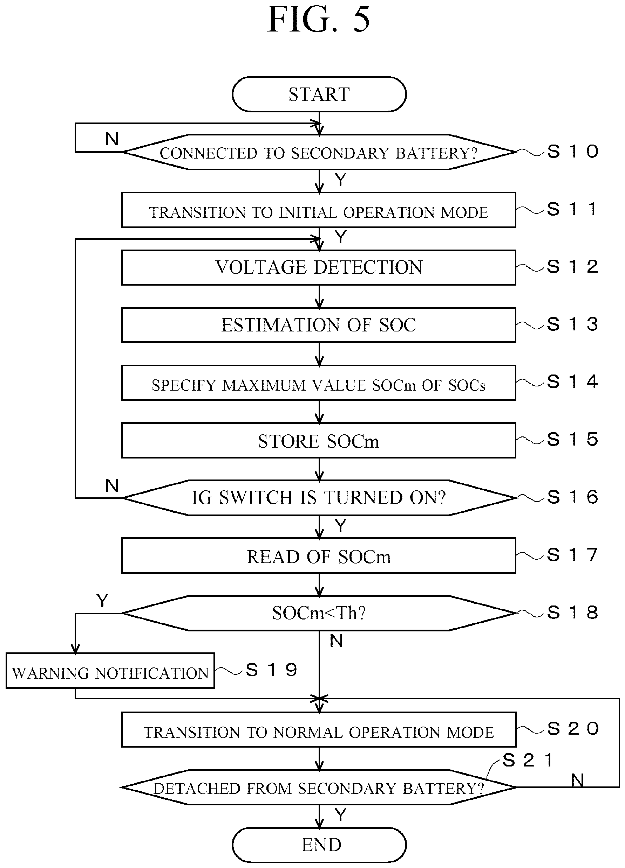

Next, a flow of processes executed at the control part 10 illustrated in Fig. 2 is described with reference to Fig. 5. When a flowchart illustrated in Fig. 5 is started, the following steps are executed.

At step S10, the CPU 10a refers to, for example, the output of the voltage sensor 11, judges whether or not the secondary battery state detecting device 1 is connected to the secondary battery 14, and when it is judged to be connected (step S10: Yes), the process proceeds to step S11, and in the other cases (step S10: No), the similar processes are repeated.

At the step S11, the CPU 10a is transit to the initial operation mode M1. Note that, for example, an operation mode flag is provided at the RAM 10c, and a state of this flag may be changed in accordance with the operation mode so that the operation mode at that time can be recognized.

At step S12, the CPU 10a refers to the output of the voltage sensor 11, and detects the voltage of the secondary battery 14.

At step S13, the CPU 10a estimates the SOC based on the voltage of the secondary battery 14 detected at the step S12. Note that as an estimation method, for example, a table or a relational expression representing a relationship between the voltage of the secondary battery 14 and the SOC are stored at the RAM 10c, and it is possible to find the SOC based on the table or the relational expression. Note that the SOC may be found with reference to not only the voltage but also the output of the current sensor 12. It goes without saying that the correction process by the temperature may be executed with reference to the output of the temperature sensor 13.

At step S14, the CPU 10a specifies a maximum value SOCm from among the SOCs estimated at the step S13 up to that time. Note that as a method specifying the maximum value, for example, it is enabled such that when the SOC which is newly estimated at the step S13 is larger than the value stored as the SOCm at that time, the SOC is stored as the SOCm, and in the other cases, it is left as it is.

At step S15, the CPU 10a stores the SOCm which is specified at the step S14 to the RAM 10c. Note that the estimation and storing processes of the SOCs are able to be performed, for example, at a predetermined time interval (for example, every one minute). It goes without saying that it can be set other than one minute.

At step S16, the CPU 10a judges whether or not the IG switch is turned into on state, and when it is judged that the IG switch is in on state (step S16: Yes), the process proceeds to step S17, and in the other cases (step S16: No), the process returns to the step S12, and repeats the similar processes as the above-stated case. For example, when the IG switch is turned into on state by the assembling workers, the process proceeds to the step S17.

At the step S17, the CPU 10a reads out the SOCm stored at the RAM 10c at the step S15.

At step S18, the CPU 10a judges whether or not the maximum value SOCm read out at the step S17 is less than a predetermined threshold value Th, and when it is judged to be less than the predetermined threshold value Th (step S18: Yes), the process proceeds to step S19, and in the other cases (step S18: No), the process proceeds to step S20. Note that as the threshold value Th, for example, 80% can be used. It goes without saying that a value other than this may be used.

At the step S19, the CPU 10a notifies the warning to the higher device via, for example, the communication part 10d. For example, a display indicating that the SOC is lower than the threshold value is thereby performed at the higher device, and therefore, the assembling workers are able to know that the secondary battery 14 is not normal. Then the process proceeds to the step S20.

At the step S20, the CPU 10a is transit to the normal operation mode M2. Note that in the normal operation mode M2, for example, pulse-state discharge is performed by the discharge circuit 15 at a predetermined timing (for example, at a vehicle stop time), and the state of the secondary battery 14 is detected from the terminal voltage and the discharge current at that time.

At step S21, the CPU 10a judges whether or not the secondary battery state detecting device 1 is detached from the secondary battery 14, and when it is judged to be detached (step S21: Yes), the process is finished, and in the other cases (step S21: No), the process returns to the step S20 to execute the similar processes.

According to the above-stated processes, when the secondary battery state detecting device 1 is attached to the secondary battery 14, the mode is transit to the initial operation mode M1, the SOCs are estimated based on the terminal voltage of the secondary battery 14, the SOCm being the maximum value of the SOCs is specified to be set to be the initial SOC, and is stored at the RAM 10c. When the IG switch is operated, the SOCm stored at the RAM 10c is read out, and when the SOCm is less than the predetermined threshold value Th, warning is generated to prompt attention to the workers, and thereafter, the mode is transit to the normal operation mode M2. Besides, when the SOCm is the predetermined threshold value or more, it is possible to transit to the normal operation mode M2. Note that in the flowchart described above, the SOC is newly estimated at the step S13, and at the step S14, when the newly estimated SOC is larger than the value of the SOCm, the SOC is substituted to the SOCm, to thereby find the maximum value SOCm of the SOCs. However, the plurality of SOCs estimated at the step S13 may be remained at the memory as they are, and one having the maximum value may be specified as the SOCm from among the plurality of SOCs stored at the memory. As the flowchart illustrated in Fig. 5, the SOCm is found in each time, and thereby, it is possible to reduce a capacity of the memory storing the SOCs, and therefore, it is possible to suppress a manufacturing cost of the device.

### (D) Description of Modified Embodiment

The above-stated embodiment is an example only, and it goes without saying that the present invention is not limited to the above-described cases. For example, in the embodiment, the judgment is performed based on the maximum value of the SOCs which are estimated in plural times at the initial operation mode, but for example, the judgment may be performed based on an average value of the SOCs. Note that when the average value is found, the average value may be found by weighting in accordance with elapsed time. Specifically, a larger weighting may be performed in accordance with the elapsed time from the timing t0.

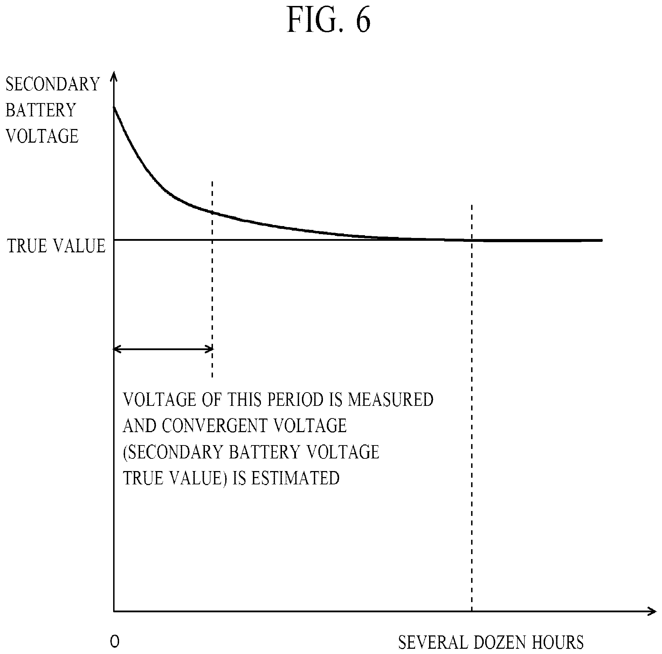

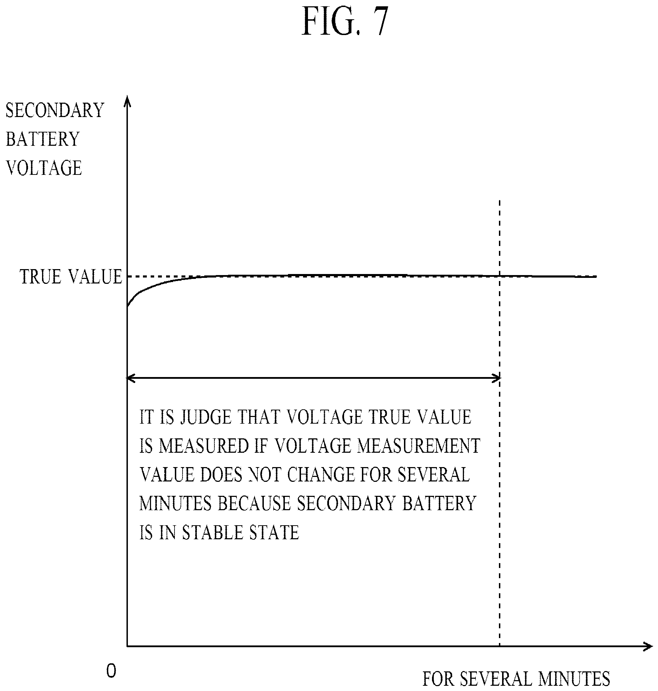

Besides, after the vehicle mounting the secondary battery 14 travels, as illustrated in Fig. 6, polarization occurs at the secondary battery 14, and a time nearly several dozen hours is necessary until this polarization falls. Therefore, conventionally, the voltage is measured at a predetermined period illustrated in Fig. 6, the true value is estimated from the change of the voltage, and the SOC is found based on the estimated value. On the other hand, at the assembling time of the vehicle, a large charge current and discharge current do not flow for the secondary battery 14, and therefore, as illustrated in Fig. 7, when the current flowing in the load 19 decreases at the load initial operation, the voltage of the secondary battery 14 converges to the true value in a short period of time (for example, in a few minutes). Accordingly, after the current for the load 19 decreases, the voltage is measured for a predetermined time (for a few minutes), and the SOC may be estimated by using the voltage when the change of the voltage becomes less than a predetermined threshold value. Note that the operation of the IG switch by the workers may be prohibited until the change of the voltage becomes less than the predetermined threshold value and the SOC is estimated.

Besides, in the above-stated embodiment, the voltage during the load initial operation is used for the estimation of the SOC, but for example, a detection value of the current sensor 12 is referred to, and the estimation of the SOC may be suspended when the discharge current flows. It is thereby possible to suspend the estimation of the SOC during the load initial operation.

Besides, in the above-stated embodiment, the warning is generated when the SOC is less than the predetermined threshold value, but the judgment may be left for the assembling workers by presenting the measured SOCs.

Besides, in the above-stated embodiment, the warning is immediately generated when the SOC is less than the predetermined threshold value, but when it is judged to be abnormal, the measurement operation of the SOC may be re-executed for one or plural times, and when it is also judged to be abnormal by the re-execution, the abnormal state may be notified. According to such a constitution, it is possible to reduce an erroneous judgment as much as possible.

Besides, the initial SOC measured in the initial operation mode is stored at the RAM 10c, and when a request is made from other devices, the initial SOC may be read out and presented, and it may be notified that an inspection of the initial SOC is passed. According to such a constitution, it is possible to know that the initial inspection is already executed and the SOC at that time, and therefore, for example, identification of a cause becomes easy even when some problems occur after a vehicle delivery.

### Explanation of Reference Signs

- 1: secondary battery state detecting device
- 10: control part
- 10a: CPU (initial state detecting unit, normal state detecting unit)
- 10b: ROM
- 10c: RAM
- 10d: display part
- 10e: I/F
- 11: voltage sensor
- 12: current sensor
- 13: temperature sensor
- 14: secondary battery
- 15: discharge circuit
- 16: alternator
- 17: engine
- 18: starter motor
- 19: load

## Claims

1. A secondary battery state detecting device (1) detecting a state of charge of a secondary battery (14) mounted on a vehicle,
wherein a first operation mode being an initial operation mode (M1) when the secondary battery state detecting device (1) is newly connected to the secondary battery (14), and a second operation mode being a normal operation mode (M2) after the first operation mode are included,
the secondary battery state detecting device (1), comprising:
an initial state detecting unit (10a) which is configured to make the operation mode transit to the first operation mode, and to detect an initial state of charge of the secondary battery (14) with reference to a terminal voltage of the secondary battery (14) in a case connected to the secondary battery (14); and
a normal state detecting unit (10a) which is configured to make the operation mode transit to the second operation mode, and to detect the state of charge of the secondary battery (14) at a normal time based on the terminal voltage and a charge/discharge current of the secondary battery (14) at a predetermined timing after the state of charge of the secondary battery (14) is detected by the initial state detecting unit (10a), wherein
the normal state detecting unit (10a) is configured to make the operation mode transit to the second operation mode when an ignition switch of the vehicle is turned into on state, and
the initial state detecting unit (10a) is configured to detect the state of charge of the secondary battery (14) in plural times, and detects the state of charge of the secondary battery (14) based on a maximum value of the plural detections or based on an average value of the plural detections.

2. The secondary battery state detecting device according to claim 1, wherein when the initial state of charge of the secondary battery (14) is judged to be not normal, the initial state detecting unit (10a) presents information indicating the state via a higher device.

3. A secondary battery state detecting method detecting a state of charge of a secondary battery (14) mounted on a vehicle,
wherein a first operation mode being an initial operation mode (M1) when the secondary battery state detecting device (1) is newly connected to the secondary battery (14), and a second operation mode being a normal operation mode (M2) after the first operation mode are included,
the secondary battery state detecting method, comprising:
an initial state detecting step which makes the operation mode transit to the first operation mode, and detects an initial state of charge of the secondary battery (14) with reference to a terminal voltage of the secondary battery (14) in a case connected to the secondary battery (14); and
a normal state detecting step which makes the operation mode transit to the second operation mode when an ignition switch of the vehicle is turned into on state, and detects the state of charge of the secondary battery (14) at a normal time based on the terminal voltage and a charge/discharge current of the secondary battery (14) at a predetermined timing after the state of charge of the secondary battery (14) is detected in the initial state detecting step, wherein
in the initial state detecting step, the initial state of charge is detected in plural times, and the state of charge of the secondary battery (14) is detected based on a maximum value of the plural detections or based on an average value of the plural detections.

## Patentansprüche

1. Sekundärbatteriezustandserfassungsvorrichtung (1) zur Erkennung eines Ladezustands einer Sekundärbatterie (14), die in einem Fahrzeug montiert ist,
wobei ein erster Betriebsmodus, der ein Ursprungsbetriebsmodus (M1) ist, in dem die Sekundärbatteriezustandserfassungsvorrichtung (1) neu mit der Sekundärbatterie (14) verbunden wird, und ein zweiter Betriebsmodus, der ein Normalbetriebsmodus (M2) nach dem der erste Betriebsmodus ist, enthalten sind,
wobei die Sekundärbatteriezustandserfassungsvorrichtung (1) umfasst:
eine Ursprungszustand-Erfassungseinheit (10a), die geeignet ist, den Betriebsmodus in den ersten Betriebsmodus zu verlegen und einen Ursprungsladezustand der Sekundärbatterie (14) in Bezug auf eine Klemmenspannung der Sekundärbatterie (14) zu erfassen, falls sie mit der Sekundärbatterie (14) verbunden ist; und
eine Normalzustand-Erfassungseinheit (10a), die geeignet ist, den Betriebsmodus in den zweiten Betriebsmodus zu verlegen und den Ladezustand der Sekundärbatterie (14) zu einer normalen Zeit auf der Grundlage der Klemmenspannung und eines Lade-/Entladestroms der Sekundärbatterie (14) zu einem vorbestimmten Zeitpunkt, nachdem der Ladezustand der Sekundärbatterie (14) durch die Ursprungszustand-Erfassungseinheit (10a) erfasst wurde, zu erfassen, wobei
die Normalzustand-Erfassungseinheit (10a) geeignet ist, den Betriebsmodus in den zweiten Betriebsmodus zu verlegen, wenn ein Zündschalter des Fahrzeugs in einen Ein-Zustand geschaltet ist, und
die Ursprungszustand-Erfassungseinheit (10a) geeignet ist, den Ladezustand der Sekundärbatterie (14) in mehrere Male zu erfassen und den Ladezustand der Sekundärbatterie (14) auf der Grundlage eines Maximalwerts der mehreren Erfassungen oder auf der Grundlage eines Durchschnittswerts der mehreren Erfassungen zu erfassen.

2. Sekundärbatteriezustandserfassungsvorrichtung nach Anspruch 1, wobei, falls der Ursprungsladezustand der Sekundärbatterie (14) als nicht normal beurteilt wird, die Ursprungszustand-Erfassungseinheit (10a) eine Information, die den Zustand anzeigt, über eine übergeordnete Vorrichtung präsentiert.

3. Sekundärbatteriezustandserfassungsverfahren zum Erfassen eines Ladezustands einer in einem Fahrzeug montierten Sekundärbatterie (14),
wobei ein erster Betriebsmodus, der ein Ursprungsbetriebsmodus (M1) ist, in dem die Sekundärbatteriezustandserfassungsvorrichtung (1) neu mit der Sekundärbatterie (14) verbunden wird, und ein zweiter Betriebsmodus, der ein Normalbetriebsmodus (M2) nach dem der erste Betriebsmodus ist, enthalten sind,
wobei das Sekundärbatteriezustandserfassungsverfahren, umfasst:
einen Ursprungszustand-Erfassungsschritt, der den Betriebsmodus in den ersten Betriebsmodus verlegt und einen Ursprungsladezustand der Sekundärbatterie (14) in Bezug auf eine Klemmenspannung der Sekundärbatterie (14), falls mit der Sekundärbatterie (14) verbunden, erfasst; und
einen Normalzustands-Erfassungsschritt, der den Betriebsmodus in den zweiten Betriebsmodus verlegt, wenn ein Zündschalter des Fahrzeugs in einen Ein-Zustand geschaltet wird, und den Ladezustand der Sekundärbatterie (14) zu einer normalen Zeit auf der Grundlage der Klemmenspannung und eines Lade-/Entladestroms der Sekundärbatterie (14) zu einem vorbestimmten Zeitpunkt erfasst, nachdem der Ladezustand der Sekundärbatterie (14) in dem Ursprungszustand-Erfassungsschritt erfasst wurde, wobei
in dem Ursprungszustand-Erfassungsschritt wird der Ursprungsladezustand in mehrere Male erfasst, und der Ladezustand der Sekundärbatterie (14) wird auf der Grundlage eines Maximalwerts der mehreren Erfassungen oder auf der Grundlage eines Durchschnittswerts der mehreren Erfassungen erfasst.

## Revendications

1. Dispositif de détection d'état de batterie secondaire (1) détectant l'état de charge d'une batterie secondaire (14) montée sur un véhicule,
dans lequel un premier mode d'opération étant un mode d'opération initial (M1) lorsque le dispositif de détection d'état de batterie secondaire (1) est nouvellement connecté à la batterie secondaire (14), et un second mode d'opération étant un mode d'opération normal (M2) après le premier mode d'opération sont inclus,
le dispositif de détection d'état de batterie secondaire (1) comprenant :
une unité de détection d'état initial (10a) qui est configurée pour faire passer le mode d'opération au premier mode d'opération, et pour détecter un état de charge initial de la batterie secondaire (14) en référence à une tension aux bornes de la batterie secondaire (14) lorsqu'elle est connectée à la batterie secondaire (14) ; et
une unité de détection d'état normal (10a) qui est configurée pour faire passer le mode d'opération au second mode d'opération, et pour détecter l'état de charge de la batterie secondaire (14) à un moment normal sur la base de la tension aux bornes et d'un courant de charge/décharge de la batterie secondaire (14) à un moment prédéterminé après que l'état de charge de la batterie secondaire (14) ait été détecté par l'unité de détection d'état initial (10a), dans lequel
l'unité de détection d'état normal (10a) est configurée pour faire passer le mode d'opération au second mode d'opération lorsqu'un contacteur d'allumage du véhicule est mis en position marche, et
l'unité de détection d'état initial (10a) est configurée pour détecter l'état de charge de la batterie secondaire (14) en plusieurs fois, et pour détecter l'état de charge de la batterie secondaire (14) sur la base d'une valeur maximale des plusieurs détections ou sur la base d'une valeur moyenne des plusieurs détections.

2. Dispositif de détection d'état de batterie secondaire selon la revendication 1,
dans lequel, lorsque l'état de charge initial de la batterie secondaire (14) est jugé non normal, l'unité de détection d'état initial (10a) présente une information indiquant l'état par l'intermédiaire d'un dispositif supérieur.

3. Procédé de détection d'état d'une batterie secondaire détectant l'état de charge d'une batterie secondaire (14) montée sur un véhicule,
dans lequel un premier mode d'opération étant un mode d'opération initial (M1) lorsque le dispositif de détection d'état de batterie secondaire (1) est nouvellement connecté à la batterie secondaire (14), et un second mode d'opération étant un mode d'opération normal (M2) après le premier mode d'opération sont inclus,
le procédé de détection d'état de la batterie secondaire, comprenant :
une étape de détection d'état initial qui fait passer le mode d'opération au premier mode d'opération, et qui détecte un état de charge initial de la batterie secondaire (14) en référence à une tension aux bornes de la batterie secondaire (14) lorsque connecté à la batterie secondaire (14) ; et
une étape de détection d'état normal qui fait passer le mode d'opération au second mode d'opération lorsqu'un commutateur d'allumage du véhicule est mis en position marche, et qui détecte l'état de charge de la batterie secondaire (14) à un moment normal sur la base de la tension aux bornes et d'un courant de charge/décharge de la batterie secondaire (14) à un moment prédéterminé après que l'état de charge de la batterie secondaire (14) ait été détecté dans l'étape de détection d'état initial, dans lequel
dans l'étape de détection d'état initial, l'état de charge initial est détecté en plusieurs fois, et l'état de charge de la batterie secondaire (14) est détecté sur la base d'une valeur maximale des détections multiples ou sur la base d'une valeur moyenne des détections multiples.
